# Europäisches Patentamt
# European Patent Office
# Office européen des brevets

(19)

(11) Numéro de publication: **0 117 375**
**B1**

(12)

# FASCICULE DE BREVET EUROPÉEN

(45) Date de publication du fascicule du brevet:
**08.04.87**

(21) Numéro de dépôt: **83402422.6**

(22) Date de dépôt: **14.12.83**

(51) Int. Cl.⁴: **H 04 N 3/15,** H 01 L 27/14,
H 04 N 5/243

(54) **Dispositif de modulation de la sensibilité d'un dispositif photosensible à transfert de ligne.**

(30) Priorité: **23.12.82 FR 8221628**

(43) Date de publication de la demande:
**05.09.84 Bulletin 84/36**

(45) Mention de la délivrance du brevet:
**08.04.87 Bulletin 87/15**

(84) Etats contractants désignés:
**DE GB NL**

(56) Documents cité:
**EP-A-0 075 696**
**FR-A-2 481 553**
**GB-A-2 083 968**
**US-A-3 931 463**

(73) Titulaire: **THOMSON- CSF, 173, Boulevard
Haussmann, F-75379 Paris Cedex 08 (FR)**

(72) Inventeur: **Berger, Jean- Luc, c/o THOMSON- CSF
173 bld Haussmann, F-75379 Paris Cédex 08 (FR)**
Inventeur: **Brissot, Louis, c/o THOMSON- CSF 173
bld Haussmann, F-75379 Paris Cédex 08 (FR)**

(74) Mandataire: **Mayeux, Michèle, THOMSON- CSF
SCPI 19, avenue de Messine, F-75008 Paris (FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

La présente invention concerne un dispositif de modulation de la sensibilité d'un dispositif photosensible à transfert de ligne.

On connaît dans l'art antérieur, notamment par les demandes de brevets français n° 2.481.553 et 2.504.334, des dispositifs photosensibles dont l'analyse s'effectue par transfert de ligne.

On rappelle que d'une façon générale, ces dispositifs comportent une zone photosensible constituée de M lignes de N points photosensibles chacune. Les points photosensibles des différentes lignes sont reliés en parallèle par des colonnes conductrices à une mémoire. Cette mémoire assure périodiquement le transfert vers un registre de lecture des charges-signal recueillies sur une ligne de points photosensibles et transférées sur les colonnes. De plus, cette mémoire assure périodiquement le transfert vers un drain d'évacuation des charges-parasites se trouvant sur les colonnes avant l'arrivée surles colonnes des charges-signal de l'une des lignes.

Les dispositifs photosensibles à transfert de ligne qui sont connus ont une sensibilité qui n'est pas variable. Or pour les différentes applications de ces dispositifs telles que les caméras grand public, la robotique.., il est intéressant de disposer de l'équivalent d'un diaphragme, c'est-à-dire de pouvoir moduler la sensibilité du dispositif en fonction de l'éclairement incident.

On sait moduler la sensibilité des dispositifs photosensibles à l'état solide en faisant varier leur temps d'intégration.

La conception de dispositifs photosensibles à transfert de ligne à sensiblité variable par modulation du temps d'intégration pose des problèmes que la présente invention permet de résoudre.

La présente invention concerne un dispositif de modulation de la sensibilité d'un dispositif photosensible à transfert de ligne, ce dispositif comportant une zone photosensible de M lignes de N points photosensibles, les points photosensibles des différentes lignes étant reliés en parallèle par des colonnes conductrices à une mémoire qui assure le transfert vers un registre de lecture des charges-signal d'une même ligne et qui assure le transfert vers un drain d'évacuation des charges-parasites se trouvant sur les colonnes avant l'arrivée des charges-signal, caractérisé en ce qu'il comporte des premiers et des seconds moyens:

-les premiers moyens assurant une première lecture de chaque ligne pendant l'intervalle de temps où les charges en provenance des colonnes sont évacuées par la mémoire vers le drain, ce qui produit l'évacuation vers le drain des charges résultant de la première lecture en même temps que les charges parasites;

- les seconds moyens assurant, après un intervalle de temps réglable, une deuxième lecture de chaque ligne pendant l'intervalle de temps où les charges en provenance des colonnes sont transférées par la mémoire dans le registre de lecture, ce qui produit le transfert vers le registre de lecture des charges-signal résultant de la deuxième lecture et en ce que les premiers et les seconds (5) moyens comportent un registre à décalage ($R_1$, $R_2$) dont les M étages adressent les M lignes de la zone photosensible (1) par l'intermédiaire de transistors (TMOS 1, TMOS 2, TMOS TAC et TMOS F), une impulsion de commande ($I_D$, $I_F$) étant injectée à l'entrée de chaque registre et transférée périodiquement d'un étage à l'autre et en ce que la modulation de l'intervalle de temps séparant la première et la deuxième lecture de la même ligne s'obtient en faisant varier le temps qui sépare l'injection de l'impulsion de commande dans chaque registre.

Parmi les avantages du dispositif selon l'invention, on peut notamment citer l'intérêt de disposer d'une modulation de sensibilité réalisée électroniquement, par rapport aux modulations de sensibilité utilisant des asservissements mécaniques commandant un diaphragme et qui sont très encombrants.

D'autres objets, caractéristiques et résultats de l'invention ressortiront de la description suivante, donnée à titre d'exemple non limitatif et illustrée par les figures annexées qui représentent:

- la figure 1, le schema d'un mode de realisation du dispositif selon l'invention;

- les figures 2a à h et 3a et b, des signaux de commande utilisés dans le dispositif de la figure 1.

Sur les différentes figures, les mêmes repères désignent les mêmes éléments, mais, pour des raisons de clarté, les cotes et proportions des divers éléments ne sont pas respectées.

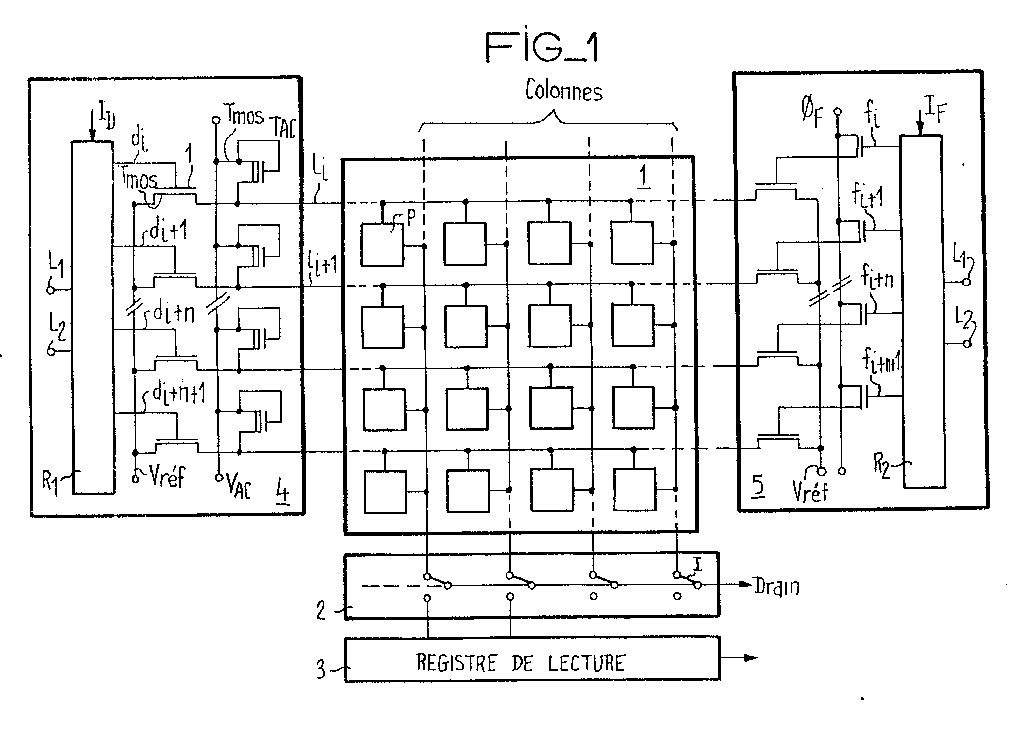

La figure 1 représente le schéma d'un mode de réalisation du dispositif selon l'invention.

Sur la figure 1, on a représenté schématiquement une zone photosensible 1, constituée d'une matrice de M lignes comportant chacune N points photosensibles P. Cette zone reçoit l'image lumineuse à analyser et la transforme en charges électriques dites charges-signal $Q_S$. Les points photosensibles d'une colonne sont reliés par une même colonne conductrice. Les colonnes conductrices aboutissent à une mémoire 2. Cette mémoire comporte des moyens de commutation symbolisés par des interrupteurs I et conduisant les chargesse trouvant sur les colonnes conductrices, soit vers un drain d'évacuation, soit vers un registre de lecture 3. La mémoire assure donc périodiquement le transfert vers le registre de lecture des charges-signal $Q_S$ recueillies sur une ligne de points photosensibles et transférées sur les colonnes. De plus, la mémoire assure périodiquement le transfert vers un drain d'évacuation des charges-parasites se trouvant sur les colonnes avant l'arrivée sur les colonnes des charges-signal de l'une des lignes.

Dans l'art antérieur, les points photosensibles d'une même ligne sont reliés entre eux ainsi qu'à un registre d'adressage qui permet de sélectionner la ligne de la matrice qui va être lue.

Il peut y avoir deux registres d'adressage, l'un adressant les lignes paires et l'autre les lignes impaires.

Dans l'art antérieur, le temps d'intégration des différentes lignes est constant. Les points photosensibles intègrent en permanence les charges créées par le rayonnement à analyser, excepté pendant les quelques micro-secondes nécessaires à chaque ligne pour déverser à tour de rôle les charges qu'elle a intégrées sur les colonnes.

L'invention permet d'obtenir une modulation de la sensibilité du dispositif photosensible en faisant varier le temps d'intégration des points photosensibles.

L'invention consiste à effectuer, pour chaque ligne, une première et une deuxième lectures, séparées par un intervalle de temps reglable, les charges résultant de la première lecture étant évacuées vers le drain en même temps que les charges-parasites et les charges-signal résultant de la deuxième lecture étant transférées vers le registre de lecture.

Le temps d'intégration des différentes lignes est constitué par l'intervalle de temps séparant la première et la deuxième lectures. On obtient un temps d'intégration variable en faisant varier cet intervalle de temps.

Le dispositif selon l'invention comporte donc, comme cela est représenté sur la figure 1, des premiers moyens 4 assurant la première lecture de chaque ligne pendant l'intervalle de temps où les charges en provenance des colonnes sont évacuées par la mémoire vers le drain et des seconds moyens 5 assurant, après un intervalle de temps réglable, la deuxième lecture de chaque ligne pendant l'intervalle de temps où les charges en provenance des colonnes sont transférées par la mémoire dans le registre de lecture.

Dans le mode de réalisation de l'invention qui est représenté sur la figure 1, ces premiers et ces seconds moyens comportent un registre à décalage de M étages qui adresse les M lignes de la zone photosensible par l'intermédiaire de transistors.

Une impulsion de commande est injectée à l'entrée de chaque registre et transférée périodiquement d'un étage du registre au suivant. La modulation de l'intervalle de temps séparant la première et la deuxième lecture s'obtient en faisant varier le temps qui sépare l'injection de l'impulsion de commande $I_D$ et $I_F$ dans chaque registre $R_1$ et $R_2$.

Les registres à décalage $R_1$ et $R_2$ des moyens 4 et 5 sont de préférence des registres à décalage réalisés avec des transistors MOS et commandés par deux phases $L_1$ et $L_2$.

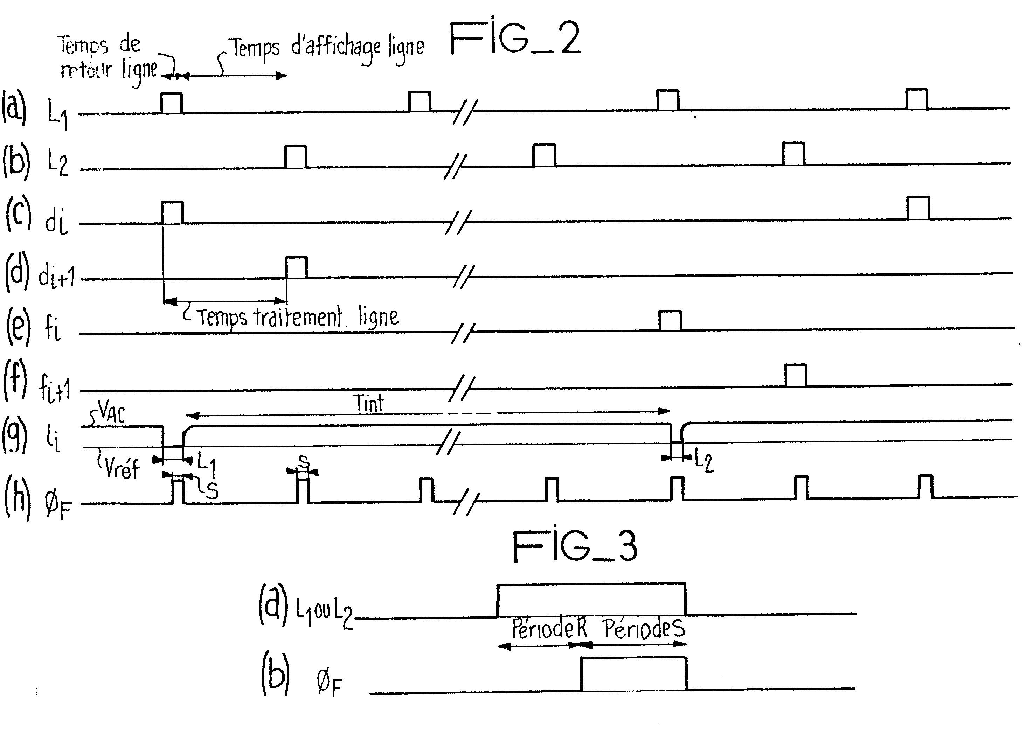

On va expliquer de façon détaillée le fonctionnement du mode de réalisation du dispositif selon l'invention qui est représenté sur la figure 1 en se référant aux signaux de commande de ce dispositif qui sont représentés sur les figures 2a à h et 3a et b. La description suivante se place dans le cas de points photosensibles constitués par des photo-MOS ou par l'association de photo-MOS et de photodiodes et réalisés sur un substrat semiconducteur de type P.

Dans ce mode de réalisation, les registres à décalage $R_1$ et $R_2$ sont commandés par les mêmes signaux d'adressage $L_1$ et $L_2$, qui sont représente sur les figures 2a et b.

Les signaux $L_1$ et $L_2$ sont au niveau haut pendant un temps de retour ligne sur deux. On rappelle que l'on désire généralement que les dispositifs photosensibles soient compatibles avec les standards habituels de la télévision; pour le standard 625 lignes, on dispose de 52 μs environ pour le temps d'affichage d'une ligne et de 12 μs pour le temps de retour ligne.

L'impulsion de commande, $I_D$ et $I_F$, qui est injectée à l'entrée de chaque registre, $R_1$ et $R_2$, est présente sur l'une des sorties de ces registres pendant chaque temps de retour ligne.

Sur les figures 2c et d, et 2e et f, on a represente les signaux obtenus sur les sorties $d_i$ et $d_{i+1}$ du registre $R_1$ et sur les sorties $f_i$ et $f_{i+1}$ du registre $R_2$, ces sorties adressent deux lignes consécutives $l_i$ et $l_{i+1}$ de la zone photosensible.

L'intervalle de temps qui sépare le passage de l'impulsion de commande d'un étage d'un registre au suivant est égal au temps consacré au traitement d'une ligne.

Dans le mode de réalisation de la figure 1, les étages du registre $R_1$ des premiers moyens 4 sont reliés à une série de transistors MOS à enrichissement désignés par la référence TMOS 1. Ces TMOS sont reliés d'une part à l'une des lignes de la zone photosensible et d'autre part à une tension de polarisation qui permet lorsqu'elle est appliquée aux grilles des photo-MOS le transfert des charges stockées par ces points sur les colonnes, c'est-à-dire la lecture d'une ligne. Sur la figure 1, cette tension est la tension de référence Vréf du dispositif. La grille des TMOS 1 est reliée à un étage du registre à décalage $R_1$. L'arrivée de l'impulsion de commande $I_D$ sur un étage rend conducteur le TMOS 1 associé à cet étage et déclenche la lecture de la ligne de la zone photosensible correspondante qui reçoit la tension de polarisation Vréf.

Les premiers moyens 4, de la figure 1 comprennent une autre série de transistors MOS à déplétion appélés TMOS TAC. Ces TMOS sont montés en suiveur entre une ligne de la zone photosensible et une tension de polarisation $V_{AC}$ qui permet lorsqu'elle est appliquée aux photo-MOS l'intégration des charges.

Le départ de l'impulsion de commande $I_D$ d'un étage bloque le TMOS 1 associé à cet étage, à ce moment-là le TMOS TAC correspondant impose sur la ligne adressée par cet étage la tension V ce qui met fin à la lecture des charges de cette ligne et marque le début de sa période d'intégration.

Sur la figure 2g, on a représenté la tension de polarisation reçue par la ligne $l_i$ de la zone photosensible. Cette tension passe de $V_{AC}$ à Vréf pendant le temps de retour ligne où l'impulsion de commande $I_D$ se trouve sur la sortie $d_i$ du

registre $R_1$.

On a vu précédemment que dans les dispositifs photosensibles à transfert de ligne, il y a répétition, de façon périodique, des deux séquences suivantes:

- une première séquence correspondant au transfert vers la mémoire des charges-parasites se trouvant sur les colonnes, avant l'arrivée des charges-signal sur les colonnes;

- une seconde séquence correspondant au transfert vers la mémoire des charges-signal d'une ligne se trouvant sur les colonnes. Dans le mode de réalisation de la figure 1, ces deux séquences ont lieu pendant le temps de retour ligne. Le temps de retour ligne comporte deux périodes comme cela est représenté sur la figure 3a, une période R pendant laquelle se produit la première séquence puis une période S pendant laquelle se produit la deuxième séquence.

La lecture qui est réalisée sur la ligne $l_i$ - voir figure 2g - alors que l'impulsion de commande se trouve sur la sortie $d_i$, commence avec le début du temps de retour ligne, pendant une période R. Les charges transférées de la ligne $l_i$ sur les colonnes sont donc évacuées vers la mémoire puis vers le drain. La fin du temps de retour ligne marque la fin de la première lecture $L_1$ de la ligne $l_i$ et le début de la période d'intégration Tint de cette ligne.

Les sorties du registre $R_2$ des moyens 5 sont reliées à la grille de transistors MOS appelés TMOS F. Les TMOS F sont reliés d'une part à un signal d'horloge $\emptyset$ représenté sur les figure 2h et 3b qui passe au niveau haut pendant la période S du temps de retour ligne et d'autre part à la grille d'une autre série de transistors MOS appelés TMOS 2.

Un TMOS F devient conducteur lorsque l'impulsion de commande $l_F$ arrive sur l'étage du registre auquel ce TMOS est relié mais sa conduction ne dure que pendant la période S du temps de retour ligne, à cause du signal $\emptyset_F$.

Chaque TMOS F commande la grille d'un TMOS 2 relié à une ligne de la zone photosensible et à la tension de polarisation Vréf qui permet la lecture des points d'une ligne.

Un TMOS F qui conduit provoque par l'intermédiaire d'un TMOS 2 l'application de la tension de polarisation Vréf à la ligne correspondante de la zone photosensible et donc la lecture de cette ligne.

Sur la figure 2g, on voit que la deuxième lecture $L_2$ de la ligne $l_i$ a lieu pendant la période S du temps de retour ligne où l'impulsion $l_F$ se trouve sur la sortie $f_i$. Le début de cette deuxième lecture marque la fin de la période d'intégration de la ligne $l_i$.

La deuxième lecture $L_2$ de la ligne $l_i$ ayant lieu pendant la période S du temps de retour ligne, ce qui fait que les charges transférées de la ligne $l_i$ sur les colonnes sont envoyées par la mémoire vers le registre de lecture 3.

On fait donc varier le temps d'intégration des lignes de la zone photosensible en modulant l'intervalle de temps qui sépare l'arrivée d'une impulsion de commande sur les sorties $d_i$ et $f_i$ des deux registres qui adressent la même ligne $l_i$ de la zone photosensible.

Pendant chaque temps de retour ligne, on effectue donc dans le procédé selon l'invention, d'abord la première lecture $L_1$ d'une ligne $l_{i+n}$ par exemple, pendant la période R, puis la seconde lecture $L_2$ d'une ligne $l_i$ par exemple, pendant la période S.

L'invention permet de faire varier le temps d'intégration dans de grandes proportions. Les lectures $L_1$ et $L_2$ d'une ligne $l_i$ peuvent être réalisées au cours de deux temps de retour ligne consécutifs. Dans ce cas, la période d'intégration est de 64 µs dans le standard 625 lignes. La période d'intégration peut varier jusqu'a environ (M -1), 64 µs où M est le nombre de lignes de la zone photosensible.

Le mode de réalisation de la figure 1 peut être aisément adapté à des dispositifs à transfert de ligne dans lesquels les deux séquences d'évacuation des charges-parasites et de lecture des charges-signal n'ont pas lieu pendant le temps de retour ligne. Il suffit de modifier les signaux de commande.

L'invention s'applique de la même façon lorsque les points photosensibles sont constitués par des photodiodes. Simplement dans le cas de photodiodes, les tensions Vréf et $V_{AC}$ sont appliquées non pas aux photo-MOS mais à des grilles qui contrôlent le passage entre les photodiodes et les colonnes et qui ne sont pas exposées au rayonnement. Lorsque les photodiodes sont réalisées sur un substrat de type P, la tension Vréf appliquée aux grilles et qui provoque la lecture des photodiodes est supérieure à la tension $V_{AC}$ appliquée aux grilles et qui permet l'intégration des charges.

Il est bien entendu que l'invention s'applique aisement à des points photosensibles réalisés sur un substrat de type N.

**Revendications**

1. Dispositif de modulation de la sensibilité d'un dispositif photosensible à transfert de ligne, ce dispositif comportant une zone photosensible (1) de M lignes de N points photosensibles, les points photosensibles (P) des différentes lignes étant reliés en parallèle par des colonnes conductrices à une mémoire (2) qui assure le transfert vers un registre de lecture (3) des charges-signal ($Q_S$) d'une même ligne et qui assure le transfert vers un drain d'évacuation des charges-parasites ($Q_B$) se trouvant sur les colonnes avant l'arrivée des charges-signal, caractérisé en ce qu'il comporte des premiers (4) et des seconds (5) moyens:

- les premiers moyens (4) assurant une première lecture ($L_1$) de chaque ligne pendant l'intervalle de temps où les charges en provenance des colonnes sont évacuées par la mémoire (2) vers le drain, ce qui produit l'évacuation vers le drain des charges résultant de la première lecture en même temps que les charges parasites;

-les seconds moyens (5) assurant, après un intervalle de temps réglable, une deuxième lecture ($L_2$) de chaque ligne pendant l'intervalle de temps où les charges en provenance des colonnes sont transférées par la mémoire (2) dans le registre de lecture (3) ce qui produit le transfert vers le registre de lecture (3) des charges-signal résultant de la deuxième lecture et

en ce que les premiers et les seconds (5) moyens comportent un registre à décalage ($R_1$, $R_2$) dont les M étages adressent les M lignes de la zone photosensible (1) par l'intermédiaire de transistors (TMOS 1, TMOS 2, TMOS TAC et TMOS F) une impulsion de commande ($I_D$, $I_F$) étant injectée à l'entrée de chaque registre et transférée périodiquement d'un étage à l'autre et en ce que la modulation de l'intervalle de temps séparant la première et la deuxième lecture de la même ligne s'obtient en faisant varier le temps qui sépare l'injection de l'impulsion de commande dans chaque registre.

2. Dispositif selon la revendication 1, caractérisé en ce qu'il s'agit de registres à décalages ($R_1$, $R_2$) constitués de transistors MOS.

3. Dispositif selon l'une des revendications 1 ou 2, caractérisé en ce que l'intervalle de temps qui sépare le passage des impulsions de commande d'un étage d'un registre au suivant est égal au temps consacré au traitement d'une ligne.

4. Dispositif selon l'une des revendications 1 à 3, caractérisé en ce que les premiers moyens comportent les deux séries de M transistors MOS suivantes:

- les transistors de l'une des séries sont des transistors MOS à enrichissement (TMOS 1) reliés d'une part à une ligne de la zone photosensible et d'autre part à une tension de polarisation (Vréf) qui permet le transfert des charges des points photosensibles sur les colonnes, la grille de ces transistors étant reliée à un étage du registre à décalage, l'arrivée d'une impulsion ($I_D$) dans un étage déclenchant la lecture de la ligne adressée par cet étage;

- les transistors de l'autre série (TMOS TAC) sont des transistors MOS à déplétion montés en suiveur et reliés d'une part à une ligne de la zone photosensible et d'autre part à une tension de polarisation ($V_{AC}$) qui permet l'intégration des charges dans les points photosensibles, le départ d'une impulsion d'un étage déclenchant le début de la période d'intégration de la ligne adressée par cet étage.

5. Dispositif selon l'une des revendications 1 à 4, caractérisé en ce que les seconds moyens (5) comportent les deux séries de M transistors MOS à enrichissement suivantes:

-les transistors d'une première série (TMOS 2) sont reliés d'une part à une ligne de la zone photosensible et d'autre part à une tension de polarisation (Vréf) qui permet le transfert des charges des points photosensibles sur les colonnes, la grille de ces transistors étant reliée à un transistor de l'autre série;

- les transistor d'une deuxième série (TMOS F) sont également reliés à un signal d'horloge ($\dot{Q}$) qui indique l'intervalle de temps où les charges en provenance des colonnes sont transférées par la mémoire (2) dans le registre de lecture (3) la grille de ces transistors étant reliée à un étage du registre à décalage ($R_2$) des seconds moyens, l'arrivée d'une impulsion ($I_F$) sur un étage rendant conducteur le transistor de la deuxième série relié à cet étage, et cela pendant l'intervalle de temps où les charges en provenance des colonnes sont transférées par la mémoire (2) dans le registre de lecture (3) la conduction de ce transistor déclenchant celle du transistor de la première série (TMOS 2) correspondant et donc la lecture d'une ligne de la zone photosensible.

6. Dispositif selon l'une des revendications 1 à 5, caractérisé en ce que les points photosensibles sont constitués par des photo-MOS, des photodiodes ou par l'association de photodiodes et de photo-MOS.

**Patentansprüche**

1. Vorrichtung zum Modulieren der Empfindlichkeit einer photoempfindlichen Vorrichtung, die mit Zeilenübertrag arbeitet, wobei diese Vorrichtung eine photoempfindliche Zone (1) aus M Zeilen zu N photoempfindlichen Punkten umfaßt, wobei die photoempfindlichen Punkte (P) der verschiedenen Zeilen parallel durch leitende Spalten mit einem Speicher (2) Verbunden sind, welcher die Überführung in ein Leseregister (3) zum Auslesen der Signalladungen ($Q_S$) derselben Zeile gewährleistet sowie die Überführung der Störladungen ($Q_B$), die sich vor der Ankunft der Signalladungen an den Spalten befinden, zu einer Abführsenke gewährleistet, dadurch gekennzeichnet, daß sie erste (4) und zweite (5) Mittel enthält:

- wobei die ersten Mittel (4) ein erstes Auslesen ($L_1$) jeder Zeile während des Zeitintervalls gewährleisten, worin die Ladungen von den Spalten durch den Speicher (2) zu der Senke abgeführt werden, wodurch die Abführung der Ladungen, welche aus dem ersten Auslesen resultieren, gleichzeitig mit den Störladungen zur Senke bewirkt wird;

- wobei die zweiten Mittel (5) nach einem einstellbaren Zeitintervall ein zweites Auslesen ($L_2$) jeder Zeile während des Zeitintervalls gewährleisten, worin die Ladungen von den Spalten durch den Speicher (2) in das Leseregister (3) überführt werden, wodurch die Überführung der aus dem zweiten Auslesen resultierenden Signalladungen in das Leseregister (3) bewirkt wird, und daß die ersten (4) und die zweiten Mittel (5) ein Schieberegister ($R_1$, $R_2$) umfassen, dessen M Stufen die M Zeilen der photoempfindlichen Zone (1) über Transistoren (TMOS 1, TMOS 2, TMOS TAC und TMOS F) adressieren, wobei ein Steuerimpuls ($I_D$, $I_F$) in den Eingang jedes Registers eingespeist und periodisch von einer Stufe zur nächsten überführt wird, sowie daß die Modulation des Zeitintervalls, welches das erste von dem zweiten Auslesen derselben Zeile trennt, dadurch erhalten wird, daß die Zeit variiert wird, welche jeweils zwischen den Steuerimpulseinspeisungen in das Register liegt.

2. Vorrichtung nach Anspruch 1, dadurch gekennzeichnet, daß es sich um Schieberegister ($R_1$, $R_2$) handelt, die aus MOS-Transistoren gebildet sind.

3. Vorrichtung nach Anspruch 1 oder 2, dadurch gekennzeichnet, daß das Zeitintervall zwischen dem Übergang der Steuerimpulse einer Stufe des Registers zur nächsten gleich der Zeit ist, die der Verarbeitung einer Zeile zugeordnet ist.

4. Vorrichtung nach einem der Ansprüche 1 bis 3, dadurch gekennzeichnet, daß die ersten Mittel die beiden folgenden Reihen von M Transistoren vom MOS-Typ enthalten:
- die Transistoren der einen Reihe sind MOS-Transistoren vom Anreicherungstyp (TMOS 1), die einerseits mit einer Zeile der photoempfindlichen Zone und andererseits mit einer Polarisationsspannung (Vref) verbunden sind, welche die Überführung der Ladungen der photoempfindlichen Punkte auf die Spalten gestattet, wobei das Gate dieser Transistoren jeweils mit einer Stufe des Schieberegisters verbunden ist und wobei die Ankunft eines Impulses ($I_D$) in einer Stufe das Auslesen der durch diese Stufe adressierten Zeile auslöst;
- die Transistoren der anderen Reihe (TMOS TAC) sind MOS-Transistoren vom Verarmungstyp, die in Folgeschaltung angeordnet sowie einerseits mit einer Zeile der photoempfindlichen Zone und andererseits mit einer Polarisationsspannung ($V_{AC}$) verbunden sind, welche die Integration der Ladungen in den photoempfindlichen Punkten gestattet, wobei der Beginn eines Impulses einer Stufe den Beginn der Integrationsperiode der durch diese Stufe adressierten Zeile auslöst.

5. Vorrichtung nach einem der Ansprüche 1 bis 4, dadurch gekennzeichnet, daß die zweiten Mittel (5) die folgenden zwei Reihen von M Transistoren vom MOS-Anreicherungstyp enthalten:
- die Transistoren einer ersten Reihe (TMOS 2) sind einerseits mit einer Zeile der photoempfindlichen Zone und andererseits mit einer Polarisationsspannung (Vref) verbunden, welche die Überführung der Ladungen der photoempfindlichen Punkte auf die Spalten gestattet, wobei das Gate dieser Transistoren jeweils mit einem Transistor der anderen Reihe verbunden ist;
- die Transistoren einer zweiten Reihe (TMOS F) sind ferner mit einem Taktsignal ($\phi_F$) verbunden, welches das Zeitintervall angibt, worin die Ladungen von den Spalten durch den Speicher (2) in das Leseregister (3) überführt werden, wobei das Gate dieser Transistoren jeweils mit einer Stufe des Schieberegisters ($R_2$) der zweiten Mittel verbunden ist, wobei ferner die Ankunft eines Impulses ($I_F$) an einer Stufe den Transistor der zweiten, mit dieser Stufe verbundenen Reihe leitend macht, und zwar während des Zeitintervalls, worin die Ladungen von den Spalten durch den Speicher (2) in das Leseregister (3) überführt werden, und wobei der leitende Zustand dieses Transistors den des entsprechenden Transistors der ersten Reihe (TMOS 2) und folglich das Auslesen einer Zeile der photoempfindlichen Zone auslöst.

6. Vorrichtung nach einem der Ansprüche 1 bis 5, dadurch gekennzeichnet, daß die photoempfindlichen Punkte durch Photo-MOS-Elemente, Photodioden oder die Zuordnung von Photodioden mit Photo-MOS-Elementen gebildet sind.

**Claims**

1. Device for modulating the sensitivity of a photosensitive line transfer device, this device comprising a photosensitive zone (1) of M lines of N photosensitive points, the photosensitive points (P) of the different lines being connected in parallel to a memory (2) by conductive lines, the memory ensuring the transfer of the signal charges ($Q_S$) of the same line to a reading register (3) and ensuring the transfer of the parasitic charges ($Q_B$) encountered on the columns prior to the arrival of the signal charges, to an evacuation drain, characterized in that it comprises first (4) and second (5) means:
- the first means (4) ensuring a first reading ($L_1$) of each line during the time interval where the charges from the columns are evacuated by the memory (2) to the drain, thus producing the evacuation of the charges resulting from the first reading to the drain simultaneously with the parasitic charges;
- the second means (5) ensuring, after an adjustable time interval, a second reading ($L_2$) of each line during the time interval where the charges from the columns are transferred by the memory (3) into the reading register (3), thus producing the transfer of the signal charges resulting from the second reading to the reading register (3), and in that the first (4) and second (5) means comprise a shift register ($R_1$, $R_2$) the M stages of which address the M lines of the photosensitive zone (1) by means of transistors (TMOS 1, TMOS 2, TMOS TAC and TMOS F), a control pulse ($I_D$, $I_F$) being injected at the input of each register and transferred periodically from one stage to the following, and in that the modulation of the time interval separating the first and second readings of the same line is obtained by varying the time separating the control pulse injections in each register.

2. Device according to claim 1, characterized in

**0 117 375**

that the registers are shift registers ($R_1$, $R_2$) formed of MOS transistors.

3. Device according to claim 1 or 2, characterized in that the time interval separating the passage of the control pulses from one stage of a register to the following is equal to the time associated with the processing of one line.

4. Device according to any of claims 1 to 3, characterized in that the first means comprise the two following series of M transistors of MOS type:

- the transistors of one of the series are MOS transistors of enrichment type (TMOS 1) connected, on the one hand, to a line of the photosensitive zone and, on the other hand, to a polarization voltage (Vref) permitting the transfer of the charges of the photosensitive points to the columns, the gate of these transistors being connected to a stage of the shift register, the arrival of one pulse ($I_D$) in a stage triggering the reading of the line addressed by this stage;

- the transistors of the other series (TMOS TAC) being MOS-transistors of depletion type mounted in follower fashion and connected, on the one hand, to a line of the photosensitive zone and, on the other hand, to a polarization voltage ($V_{AC}$) permitting the integration of the charges in the photosensitive points, the beginning of a pulse of one stage triggering the beginning of the integration period of the line addressed by this stage.

5. Device according to any of claims 1 to 4, characterized in that the second means (5) comprise the two following series of M-transistors of MOS enrichment type:

- the transistors of a first series (TMOS 2) are connected, on the one hand, to a line of the photosensitive zone and, on the other hand, to a polarization voltage (Vref) permitting the transfer of the charges from the photosensitive points to the columns, the gates of these transistors being connected to a transistor of the other series;

- the transistors of a second series (TMOS F) being likewise connected to a clock signal ($\phi_F$) indicating the time interval where the charges from the columns are transferred by the memory (2) into the reading register (3), the gates of these transistors being connected to a stage of the shift register ($R_2$) of the second means, the arrival of a pulse ($I_F$) on a stage rendering conductive the transistor of the second series connected to this stage, which occurs during the time interval where the charges from the columns are transferred by the memory (2) to the reading register (3), the conduction of this transistor triggering that of the corresponding transistor of the first series (TMOS 2), and thus the reading of a line of the photosensitive zone.

6. Device according to any of claims 1 to 5, characterized in that the photosensitive points are formed of photo-MOS elements, photodiodes or the association of photodiodes with photo-MOS elements.

FIG_1

0117375

FIG_2

Temps de retour ligne — Temps d'affichage ligne

(a) $L_1$

(b) $L_2$

(c) $d_i$

(d) $d_{i+1}$

Temps traitement ligne

(e) $f_i$

(f) $f_{i+1}$

$V_{AC}$ — Tint

(g) $l_i$

$V_{réf}$ — $L_1$ — S — $L_2$

(h) $\emptyset_F$ — S

FIG_3

(a) $L_1$ ou $L_2$

Période R    Période S

(b) $\emptyset_F$

0 117 375